Europäisches Patentamt

European Patent Office

Office européen des brevets

(19)

(11) Publication number: **0 153 043**
A2

(12) **EUROPEAN PATENT APPLICATION**

(21) Application number: 85300598.1

(22) Date of filing: 29.01.85

(51) Int. Cl.⁴: **H 01 L 31/02**, H 01 L 31/06

(30) Priority: 15.02.84 US 580312

(43) Date of publication of application: 28.08.85
Bulletin 85/35

(84) Designated Contracting States: BE CH DE FR GB IT LI
LU NL SE

(71) Applicant: ENERGY CONVERSION DEVICES, INC.,
1675 West Maple Road, Troy Michigan 48084 (US)

(72) Inventor: Ovshinsky, Stanford R., 2700 Squirrel Road,
Bloomfield Hills Michigan 48013 (US)
Inventor: Hudgens, Stephen J., 18501 Mount Vernon
No. 2 Alexandria Towne, Southfield Michigan 48075 (US)

(74) Representative: Jackson, Peter Arthur et al, GILL
JENNINGS & EVERY 53-64 Chancery Lane, London
WC2A 1HN (GB)

(54) Ohmic contact layer.

(57) An electronic device having at least two superposed layers
of amorphous semiconductor material of differing conductivity
types and a sufficiently low number of defect states so as to
form a rectifying junction between the layers, including a de-
fect states introduction layer proximate the junction. The de-
fect introduction layer includes a sufficient density of defect
states to promote the flow of current by tunneling of charge
carriers and thereby to establish an ohmic contact. Methods of
forming the improved ohmic contact device are also disclosed.

EP 0 153 043 A2

ACTORUM AG

0153043

ENERGY CONVERSION DEVICES, INC.          Ref: 50/2590/02

OHMIC CONTACT LAYER

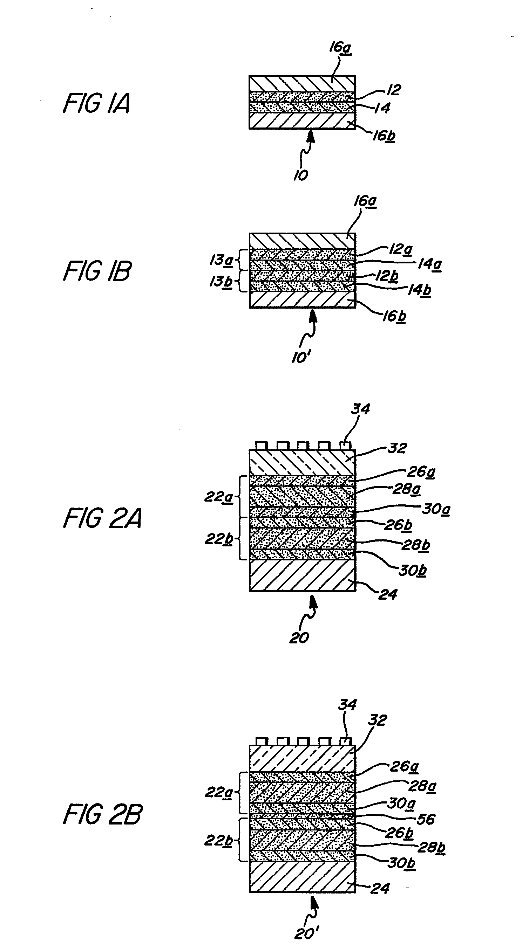

Crystalline silicon is characterized by ease of doping to form p-type and n-type materials and a low density of defect states in its band gap. In Figure 1A, a typical prior art crystalline p-n junction photovoltaic cell 10 includes a layer of p type silicon 12 in contact with a layer of n type silicon 14. Electrodes 16a and 16b establish electrical contact to layers 12 and 14, respectively, and serve as electrical terminals of cell 10. It is desirable in photovoltaic applications to have a stacked array of such cells, with each cell optimized to absorb a particular portion of the solar spectrum. Figure 1B illustrates such a "hypothetical" prior art stacked photovoltaic cell 10' including a first silicon p-layer 12a and a first silicon n-layer 14a comprising one p-n photovoltaic cell 13a. A second silicon p-layer 12b and a second silicon n-layer 14b comprise a second photovoltaic cell 13b. Electrodes 16a and 16b are generally similar to the electrodes depicted in Figure 1A. Cell 10' is described as "hypothetical" because, as illustrated, it is inoperative. At the intersection of the second p-layer 12b and the first n-layer 14a a diode or rectifying junction is formed that only allows the flow of electrical current in a direction opposite to that permitted by the junctions established by first p-layer 12a and first n-layer 14a, and second p-layer 12b and second n-layer 14b. In order for the cell 10' to pass electrical current between electrodes 16a and 16b, an ohmic contact must be formed between layers 14a and 12b. It is difficult to establish such an ohmic contact because an insufficient density of defect states exists at the interface of layers 12b and 14a to support current transport by a tunneling mechanism. Tunneling may be encouraged if a degenerately doped layer is interposed between layers 14a and 12b.

Figure 2A depicts a prior art tandem p-i-n photovoltaic device 20 including two stacked p-i-n photovoltaic cells 22a and 22b. An electrically conductive substrate 24 beneath cell 22b serves as an electrode of device 20. Substrate 24 has at least one electrically conductive surface in contact with cell 22b and is made of either an insulating material such as glass, an organic polymer or the like, with an electrically conductive layer disposed upon it, or an electrically conductive material such as stainless steel, which is preferred, or aluminum and the like. In the preferred embodiment, each of cells 22a and 22b comprises an amorphous semiconductor body containing at least a silicon or germanium alloy. The term "amorphous", as used herein, includes all materials or alloys which have long range disorder, although they may have short or intermediate range order or even contain, at times, crystalline inclusions. Each of cells 22a and 22b, respectively, includes an n-type conductivity semiconductor layer 26a and 26b, a layer of intrinsic semiconductor material 28a and 28b, and a layer of p-type semiconductor material 30a and 30b. Photovoltaic device 20 is illuminated through a light transmissive electrode 32, such as indium tin oxide, disposed on layer 26a. A current collecting grid 34 may optionally be applied on transparent conductive oxide layer 32. P-layer 30a of cell 22a and n-layer 26b of cell 22b are in direct contact. It would be expected that the diode thus formed would prevent bidirectional flow of electrical current between electrodes 24 and 32. However, in the amorphous alloys used to fabricate p-i-n photovoltaic cells 22a and 22b, a sufficiently high density of defect states (in the range of $10^{18}$ to $10^{19}$/cm$^{-3}$) exists at the interface of layers of opposite conductivity type to permit charge carriers to tunnel through, thereby establishing an ohmic junction.

Doped superlattice structures, i.e. semiconductor devices having superposed semiconductor layers of alternating conductivity types, see "Solid State Superlattics" by Gottfried H. Doehler in Scientific American, volume 249, number 5, page 144 (November, 1983), are limited in utility because of the difficulty of forming an ohmic junction between the superposed crystalline layers of differing conductivity. In crystalline superlattices the layers of alternating conductivity are typically less than 5 nanometers thick.

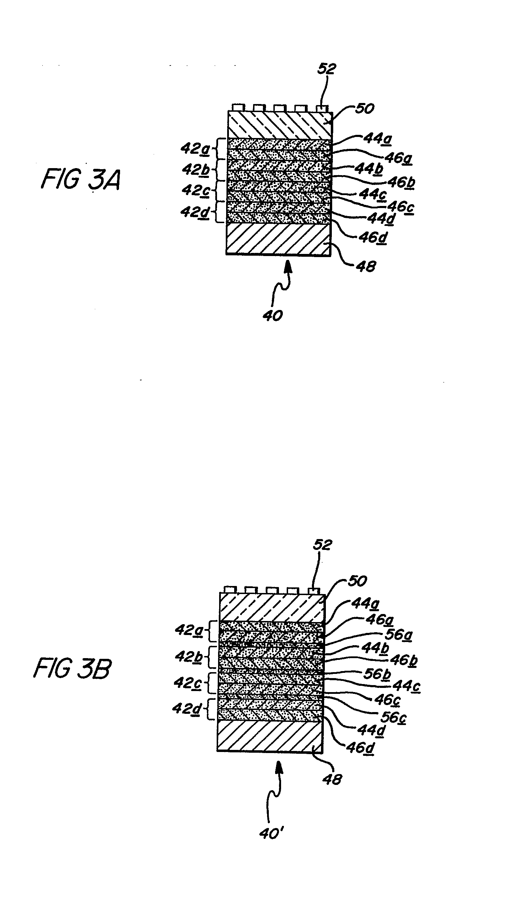

It is possible to fabricate multilayered amorphous semiconductor devices having electronic, optical and other physical properties in common with crystalline superlattices. One such device 40 is illustrated in Figure 3A. Device 40 comprises four superposed pairs of layers 42$\underline{a}$-42$\underline{d}$ of alternating p-type and n-type conductivity. Layer pair 42$\underline{a}$ comprises a layer of p-type material 44$\underline{a}$ superposed upon a layer of n-type material 46$\underline{a}$. Layer pair 42$\underline{b}$ comprises a layer of p-type material 44$\underline{b}$ superposed upon a layer of n-type material 46$\underline{b}$, and so forth. A first electrode layer 48, generally similar to electrically conductive substrate 24 of Figure 2A, is disposed on layer 46$\underline{d}$. A second electrode 50, formed of an electrically conductive transparent material, such as indium tin oxide, for receiving illumination is disposed on layer 44$\underline{a}$. A highly conductive grid pattern 52 like that one previously discussed, is deposited on second electrode 50. A semiconductor multilayered structure, such as device 40, fabricated from amorphous materials having a relatively high density of defect states, is capable of conducting an electrical current in either direction between electrodes 48 and 50 and transversely to those directions. However, a similar crystalline superlattice structure that has a relatively low density of defect states is only capable of conducting electrical currents in the transverse directions.

Lowering the density of defect states in amorphous semiconductor materials improves the electrical conductivity of those materials and reduces trapping centers, thereby improving the efficiency of devices fabricated from them. Applicants have produced amorphous semiconductor materials having a lowered density of defect states that simulate their crystalline counterparts by forming rectifying junctions when superposed layers of alternating conductivity are prepared. There is a need to provide an ohmic contact between superposed amorphous semiconductor layers of alternating conductivity that are characterized by a low density of states in order to achieve the desired performance characteristics of amorphous silicon alloys that have a large defect density. It is

- 4 -

further desired that the ohmic contact neither add significant electrical resistance to the superposed layers of alternating conductivity nor render the device opaque to light.

The instant invention fills the need by providing defect states proximate the junction of superposed amorphous semiconducting alloy layers of differing conductivity to encourage current flow by a tunneling mechanism and thereby form an ohmic contact. The invention makes possible the fabrication of amorphous semiconductor devices having electrical properties similar to devices fabricated from crystalline materials and the fabrication of amorphous semiconductor devices having no crystalline material equivalents.

In the invention, a thin layer of material having a relatively large density of defect states is disposed proximate the junction of amorphous semiconductor layers of differing conductivity. The layer introducing a relatively high level of defects may comprise a heavily doped portion of one or both of the two layers forming the junction or may be a discrete member disposed between the two layers forming the junction. A discrete defect state introduction layer may be formed in various ways. For example, voids producing defect states may be formed in a layer of material by adding a material, such as an inert gas, during the deposition of the amorphous semiconductor materials. Alternatively, the defect introduction layer may be separately deposited by sputtering.

Figure 1A is a schematic cross-sectional view of a prior art p-n junction semiconductor device.

Figure 1B is a schematic cross-sectional view of a prior art semiconductor device having two stacked p-n cells.

Figure 2A is a schematic cross-sectional view of a prior art semiconductor device including two p-i-n cells.

Figure 2B is a schematic cross-sectional view of an embodiment of a semiconductor device according to the invention including two p-i-n cells separated by a defect state introduction layer.

Figure 3A is a schematic cross-sectional view of a multilayered semiconductor device including four stacked pairs of p-n layers of semiconductor material.

Figure 3B is a schematic cross-sectional view of an embodiment of a multilayered semiconductor device according to the invention including four stacked pairs of p-n layers of semiconductor material, each pair being separated by a defect state introduction layer.

In Figure 2B a tandem p-i-n photovoltaic device 20' fabricated in accordance with the invention is illustrated. Photovoltaic device 20' is generally similar to photovoltaic device 20 of Figure 2A and the elements common to the two devices are referred to by similar reference numerals so that there is no need to repeat the description of those common elements. While the layers of amorphous semiconductor material 26, 28 and 30 of the tandem photovoltaic device 20' of Figure 2B are described as being generally similar to those in the photovoltaic device 20 of Figure 2A, they are characterized by a lower density of defect states. The density of defect states is sufficiently low in device 20' that contact between superposed layers of opposite conductivity types produces a conventional rectifying diode current-voltage characteristic. Photovoltaic device 20' includes a defect state introduction layer 56 disposed between p-type conductivity layer 30a of p-i-n photovoltaic cell 22a and n-type conductivity layer 26b of p-i-n photovoltaic cell 22b. Defect state introduction layer 56 includes a sufficient density of defect states in the region proximate the superposed p-type and n-type conductivity layers to encourage current to flow across the junction of photovoltaic cells 22a and 22b by tunneling. Embodiments of defect state introduction layer 56 may be formed from: heavily doped amorphous silicon alloys; heavily doped amorphous germanium alloys; amorphous alloys including a mixture of silicon and germanium; an amorphous alloy containing both p-type and n-type conductivity dopants; and a layer containing a very high number of surface states.

In order for defect state introduction layer 56 to effect bidirectional tunnelling conduction of charge carriers across the junction, it must establish ohmic contact to both the p-type and n-type conductivity layers, have a sufficiently high electrical conductivity so as not to add unnecessary amounts of internal resistance to photovoltaic device 20', and have a thickness less than the diffusion length of the minority charge carriers so that said minority charge carriers are able to traverse the entire thickness of layer 56. Heavily doped p-type conductivity or n-type conductivity semiconductor material having a composition generally similar, respectively, to the superposed layers or 30a and 26b of photovoltaic device 20' may be advantageously employed to form the requisite thin defect introduction layer. Such heavy doping may be achieved during the normal course of depositing the superposed p-type and n-type conductivity semiconductor layers by adding additional n dopant, typically phosphorous, to the process gas stream immediately after the deposition of n-type conductivity layer 26b of cell 22b. This step produces a heavily doped n-type conductivity region on top of and co-extensive with n-type conductivity layer 26b. Following deposition of the n-type conductivity layer, p-type conductivity layer 30a of cell 22a is deposited. The n-type layer will introduce sufficient defect states to establish ohmic contact between p-type layer 30a and n-type layer 26b. Alternatively, a high concentration of p-type dopant, typically boron, may be added to the process gas stream after the deposition of n-type layer 26b and prior to the deposition of p-type layer 30a. This step produces a heavily doped p-type conductivity region below and co-extensive with subsequently deposited p-type conductivity layer 30a. If a heavily doped conductivity layer is used to form the defect state introduction layer 56, it is preferred that its deposition occur in the same deposition chamber that the normally doped semiconductor layers are deposited. However, a dedicated chamber for the deposition of the defect state introduction layer may be provided to avoid contamination of the deposition chambers in which the lower density of defect states layers are deposited.

In most cases, a layer of heavily doped semiconductor material will be sufficient to establish ohmic contact to similarly doped, as well as oppositely doped, semiconductor material. In some cases it is necessary to employ multiple defect state introduction layers, with one portion optimized to establish ohmic contact to a semiconductor layer of a first conductivity type and another portion optimized to establish ohmic contact to a semiconductor layer of the opposite conductivity type. Defect state introduction layer 56 can have a graded or profiled composition, for example, ranging from normal doping at one surface to heavy doping at the opposite surface.

The maximum thickness of defect state introduction layer 56 is dependent upon the maximum distance which charge carriers are capable of tunnelling. Obviously, if a defect state introduction layer is too thick for charge carriers to tunnel through, a device incorporating that layer would be inoperative. The maximum tunneling distance depends upon a number of factors including the composition of the material that forms defect state introduction layer 56. A layer thickness of 2 to 3 nanometers is generally sufficiently thin for tunneling of charge carriers through it.

It is known that many unique electronic states, presenting a variety of deviant electronic configurations, exist at the surface of a material because of strained and disturbed chemical bonds, unfulfilled valencies, etc. Through appropriate techniques of fabrication, materials generally, and amorphous semiconductor materials in particular, may be formed so as to exhibit these surface states throughout their thickness. Such defect states enhance the flow of tunneling currents in their host materials. Surface states may be introduced throughout the bulk of an amorphous semiconductor material, for example, by adding an inert gas, such as argon, to a process gas stream for plasma discharge deposition of that material. The addition of the inert gas results in the formation of tiny voids within the amorphous semiconductor material effectively increasing the surface area to produce a high number of surface states.  Other techniques, such as ion bombardment, plasma and chemical treatment, and the like may be similarly employed to introduce defect states into defect states introduction layer 56.

Semiconductor layers containing a large density of defect states may also be formed by sputtering processes.  Sputtering is a process well known to those skilled in the art and is widely employed for the preparation of thin films.  Sputtered semiconductor materials, especially sputtered silicon and silicon-containing materials, generally exhibit a high density of defect states and are therefore considered unsatisfactory for the fabrication of high efficiency semiconductor devices.  However, sputtered materials may be advantageously employed to form a high density of states introduction layer in accordance with the invention.

A multilayered electronic device 40' including a plurality of superposed pairs of amorphous semiconductor layers of alternating conductivity types, with each adjacent pair of layers being spaced by a defect state introduction layer in accordance with the invention, is illustrated in Figure 3B.  Device 40' is generally similar in form to device 40 of Figure 3A.  Common elements of devices 40 and 40' are given the same reference numerals and further description of them would be repetitive and is therefore unnecessary.  In device 40' a defect introduction layer 56a, 56b and 56c is interposed between each pair of p-n layers 42a-42b, 42b-42c and 42c-42d, respectively. Defect state introduction layers are substantially identical in form and function to the defect state introducing layer described with reference to Figure 2B.  Defect state introduction layers 56a, 56b and 56c provide a relatively high density of defect states proximate each of the junctions formed between each of the layer pairs, thus allowing charge carriers to tunnel across each of the junctions. Device 40' may be considered a superlattice or a truncated superlattice in which each layer is no thicker than 5 nanometers that can conduct electrical current through the stack of layers 42a-42d.

    While multilayered photovoltaic device 40' of Figure 3B has
four superposed layer pairs, the invention is not limited to such
embodiments and may be employed with devices having greater or fewer
number of layer pairs, as well as with non-photovoltaic devices.
Further, the invention is not restricted to use with electronic or
semiconductor devices having only stacked sets of p-n or p-i-n
junctions.  For example, embodiments of the invention may be used to
form ohmic contacts between regions of differing conductivity types
in thin film amorphous semiconductor integrated circuits.  The
inventive ohmic contact may also be formed between a body of
semiconductor material and a body of a different material, such as a
metal.

CLAIMS

1.     A semiconductor device including at least two superposed amorphous semiconductor layers (44b, 46a) of differing conductivity types forming a rectifying junction characterized in that means for introducing defect states to promote the flow of current through said junction by a tunneling mechanism is disposed proximate said junction.

2.     The device of claim 1, characterized in that said at least two superposed layers include a plurality of pairs (42a, 42b, 42c, 42d) of alternating p-type (44a, 44b, 44c, 44d) and n-type (46a, 46b, 46c, 46d) conductivity.

3.     The device of claim 2 characterized in that said layers of alternating conductivity type are less than 5 nanometers thick.

4.     The device of claim 1 including at least six amorphous semiconductor layers disposed sequentially in p-type, intrinsic type and n-type conductivities to form at least two p-i-n type cells (22a, 22b) characterized in that said means for introducing defect states is disposed proximate the junction of the p-type layer (26b) of one of said cells and the n-type layer (30a) of the other cell.

5.     The device of claim 1 characterized in that said means for introducing defect states (56) includes a heavily doped portion of one (46a) of said at least two layers (46a, 44b) of differing conductivity types.

6.     The device of claim 5 characterized in that said means for introducing defect states (56) includes heavily doped portions of said at least two layers (46a, 44b) of differing conductivity types.

7.     The device of claim 1 characterized in that said means for introducing defect states comprises a discrete layer (56) containing a relatively large density of defect states, said discrete layer being disposed between said at least two layers (46a, 44b) of differing conductivity types.

8. The device of claim 7 characterized in that said discrete layer (56) includes voids producing defect states.

9. The device of claim 7 characterized in that said discrete layer (56) comprises a sputtered layer of amorphous material.

10. A method of fabricating an improved semiconductor device of the type including at least two superposed amorphous semiconductor layers of differing conductivity types forming a rectifying junction characterized by disposing, proximate said junction, means for introducing defect states to promote the flow of current through said junction by a tunneling mechanism.

11. The method of claim 10 characterized in successively depositing a plurality of pairs of alternating p-type conductivity and n-type conductivity layers.

12. The method of claim 11 characterized in depositing each of the layers of alternating conductivity to a thickness of less than 5 nanometers.

13. The method of claim 10 characterized in disposing said means for introducing defect states by heavily doping a portion of one of said at least two layers of differing conductivity types.

14. The method of claim 13 characterized in disposing said means for introducing defect states by heavily doping portions of both said at least two layers of differing conductivity types.

15. The method of claim 10 characterized in disposing said means for introducing defect states as a discrete layer between said at least two layers of differing conductivity types.

16. The method of claim 15 characterized in incorporating a material into said discrete layer to produce voids in said discrete layer.

17. The method of claim 16 characterized in that an inert gas is incorporated into said discrete layer to produce said voids.

18. The method as in claim 15 characterized in sputtering said discrete layer.

FIG IA

FIG IB

FIG 2A

FIG 2B

*FIG 3A*

52
50
42*a* {
44*a*
46*a*
42*b* {
44*b*
46*b*
42*c* {
44*c*
46*c*
42*d* {
44*d*
46*d*
48

40

*FIG 3B*

52
50
44*a*
42*a* {
46*a*
56*a*
42*b* {
44*b*
46*b*
42*c* {
56*b*
44*c*
46*c*
42*d* {
56*c*
44*d*
46*d*
48

40'